## Europäisches Patentamt
## European Patent Office
## Office européen des brevets

(19)

(11) Veröffentlichungsnummer: **0 037 483**
**B1**

(12)

# EUROPÄISCHE PATENTSCHRIFT

(45) Veröffentlichungstag der Patentschrift:
**22.08.84**

(21) Anmeldenummer: **81101948.8**

(22) Anmeldetag: **16.03.81**

(51) Int. Cl.³: **B 08 B 3/02, C 23 F 1/08**

(54) Verfahren zur Intensivierung von Spül- und Reinigungsprozessen für Perforationen in Formstücken.

(30) Priorität: **21.03.80 DE 3011061**

(43) Veröffentlichungstag der Anmeldung:
**14.10.81 Patentblatt 81/41**

(45) Bekanntmachung des Hinweises auf die Patenterteilung:
**22.08.84 Patentblatt 84/34**

(84) Benannte Vertragsstaaten:
**FR GB IT NL**

(56) Entgegenhaltungen:
**GB - A - 837 487**
**US - A - 3 082 774**

(73) Patentinhaber: **SIEMENS AKTIENGESELLSCHAFT, Berlin und München Wittelsbacherplatz 2, D-8000 München 2 (DE)**

(72) Erfinder: **Müller, Georg, Blütenstrasse 1, D-8901 Rettenbergen (DE)**
Erfinder: **Gebauer, Wolfgang, Ziegeleistrasse 12, D-8901 Inningen (DE)**

ACTORUM AG

EP 0 037 483 B1

## Beschreibung

Die Erfindung betrifft ein Verfahren zur Intensivierung von Spül- und Reinigungsprozessen für Formstücke, wie z.B. Leiterplatten, Formätzteilen und dergleichen, bei Spül- und Reinigungsautomaten, bei dem oberhalb des Transportsystems der Formstücke Spritzdüsen angeordnet sind.

Aus der Patentschrift US-A-3 082 774 ist ein derartiges Verfahren bekannt, ferner zeigt diese Druckschrift eine Ätzmaschine, bei der die Spülung nach dem Ätzen mit Hilfe eines Strahlers durchgeführt wird, der von den Düsen, die oberhalb und unterhalb des Ätzguts angebracht sind, erzeugt wird. Gerade diese Strahlreinigung weist aber erhebliche Mängel auf, da nämlich bei der Reinigung von Leiterplatten insbesondere mit Perforationen der dünne Strahl der Spritzdüsen nur kurzzeitig in den Perforationen wirksam wird, wobei es durchaus zufällig ist, ob ein derartiger Strahl eine Perforation trifft oder nicht.

In Durchlaufmaschinen in denen Formstücke mit Bohrungen oder Stanzdurchbrüchen von den Reaktions- bzw. Behandlungszonen in die Spülzonen laufen, ist es problematisch, die Behandlungslösungen (z.B. Lacke, Ätze usw.) aus den Löchern bzw. Durchbrüchen auszuspülen. Es werden erhebliche Mengen an Behandlungslösungen in die Spülkammern verschleppt, so dass dort eine einwandfreie Spülung nicht immer gewährleistet ist. Dieses Problem verstärkt sich mit Zunahme der Dichte der Bohrungen bzw. Durchbrüche pro Flächeneinheit mit Verringerung der Durchmesser der Bohrlöcher bzw. Durchbrüche, mit Zunahme der Materialdicke der Werkstücke und mit Zunahme der Rauhigkeit dieser Bohrloch- bzw. Durchbruchwandungen. Bei bekannten Verfahren versucht man im wesentlichen durch Sprühspülungen eine ausreichende Spülung zu erreichen.

Aufgabe der vorliegenden Erfindung ist es, ein Verfahren anzugeben, bei dem das Ausspülen von Behandlungslösungen aus Perforationen von Formstücken intensiviert wird.

Zur Lösung dieser Aufgabe wird dabei so verfahren, dass die mit Perforationen versehenen Formstücke nach der Behandlung in Aktivkammern mit einem Transportsystem über eine in den Spülkammern befindliche Spülmittelschwallstrecke geführt werden und dass die Schwallstrecke unterhalb der Transportbahn mit mindestens einem Schlitzrohr erzeugt wird, aus dem das Spülmittel unter Druck austritt.

Durch diese Massnahme wird eine wesentlich intensivere Durchspülung von Bohrlöchern und anderen Durchbrüchen z.B. bei gedruckten Leiterplatten erreicht, wodurch die Qualität des nachfolgenden Verzinnvorganges derartiger Formstücke wesentlich erhöht wird.

Insbesondere kann die Einrichtung auch so weitergebildet sein, dass mindestens zwei Spülkammern mit Spülmittelschwallstrecken vorgesehen sind und dass der Spülmitteleinlauf der ersten Spülkammer gegenüber dem allgemeinen Spülmitteleinlauf der zweiten Spülkammer getrennt und in sich abgeschlossen ist.

Den beiden ersten Spülkammern lässt sich vorteilhafterweise eine weitere Spülkammer mit normaler Spüldüse nachschalten.

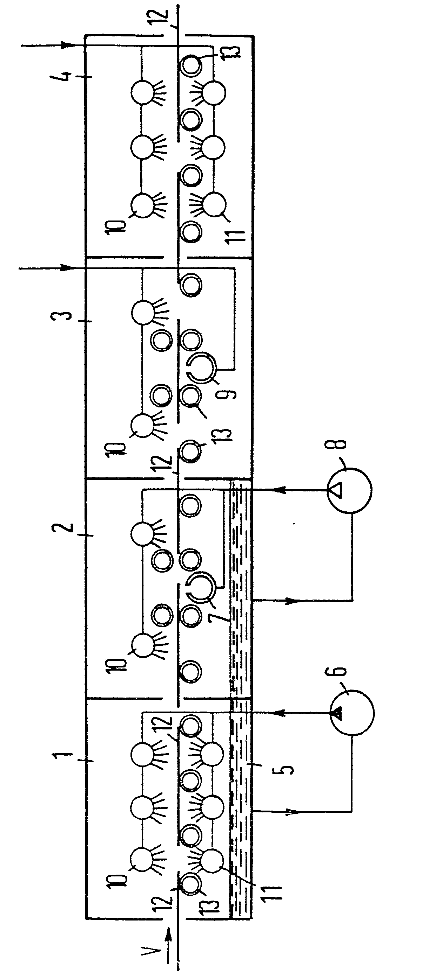

Die Figur zeigt einen Teil der Durchlaufstrasse eines Reinigungsautomaten. Die Leiterplatten 12 werden über Walzen 13 in die Aktivkammer 1 geführt. Dort wird über ein Pumpsystem 6 Ätze den Sprühdüsen 10 und 11 zugeführt. Anschliessend gelangt die Leiterplatte in eine zweite Kammer, die als Spülkammer 2 ausgebildet ist. Über der Oberseite der Leiterplatten befinden sich wieder Sprühdüsen 10, während unterseitig ein Schlitzrohr 7 vorgesehen ist. Die in dieser Kammer befindliche Spülfüssigkeit wird über ein weiteres Pumpsystem 8 sowohl den Spüldüsen 10 als auch dem Schlitzrohr 7 zugeleitet, wodurch oberhalb des Schlitzes des Schlitzrohrs 7 ein Schwall mit Spülflüssigkeit entsteht, durch den eine intensive Reinigung der Bohrungen möglich ist. In einer zweiten Spülstrecke 3, die den gleichen konstruktiven Aufbau wie die Spülstrecke 2 aufweist, wird jedoch nunmehr die Spülung über den normalen Wasserkreislauf vorgenommen, da in diesem Spülabschnitt angenommen werden kann, dass Ätzrückstände nicht mehr oder nur in einem verschwindend geringen Masse vorhanden sind. Es ist also auch für die Erfindung wesentlich, dass zwei unabhängig voneinander arbeitende Kreisläufe für die Spülflüssigkeit vorhanden sind, wobei der erste Kreislauf ein interner Kreislauf ist, während der zweite Kreislauf an den allgemeinen Wasserkreislauf einer Fabrik angeschlossen sein kann. In einer weiteren Spülstrecke 4 wird nunmehr mit normalen Spüldüsen 10 und 11 eine weitere Spülung durchgeführt, wobei die Spülflüssigkeit wiederum dem allgemeinen Wasserkreislauf entnommen ist.

## Patentansprüche

1. Verfahren zur Intensivierung von Spül- und Reinigungsprozessen für Formstücke (12), wie z.B. Leiterplatten, Formätzteilen und dergleichen, bei Spül- und Reinigungsautomaten, bei dem oberhalb des Transportsystems (13) der Formstücke (12) Spritzdüsen (10) angeordnet sind, dadurch gekennzeichnet, dass die mit Perforationen versehenen Formstücke (12) nach der Behandlung in Aktivkammern (1) mit einem Transportsystem (13) über eine in den Spülkammern (2, 3) befindliche Spülmittelschwallstrecke geführt werden und dass die Schwallstrecke unterhalb der Transportbahn mit mindestens einem Schlitzrohr (7, 9) erzeugt wird, aus dem das Spülmittel unter Druck austritt.

2. Verfahren nach Anspruch 1, dadurch gekennzeichnet, dass mindestens zwei Spülkammern (2, 3) mit Spülmittelschwallstrecken (7, 9) vorgesehen sind und dass der Spülmitteleinlauf der ersten Spülkammer (2) gegenüber dem allgemeinen Spülmittelkreislauf der zweiten Spülkammer (3) getrennt und in sich abgeschlossen ist.

3. Verfahren nach einem der vorhergehenden Ansprüche, dadurch gekennzeichnet, dass auf die ersten beiden Spülkammern (2, 3) mit Schwallstrecke eine weitere Spülkammer (4) mit normalen Spüldüsen (10, 11) folgt.

## Revendications

1. Procédé pour rendre plus intenses les processus de rinçage et de nettoyage de pièces conformées (12), comme par exemple des plaquettes de circuits imprimés, des pièces réalisées par attaque chimique et des pièces semblables, dans des installations automatiques de rinçage et de nettoyage, dans lequel des buses de projection (10) sont disposées au-dessus du système de transport (13) des pièces conformées caratérisé en ce qu'il consiste à guider les pièces conformées (12) munies de perforations, après les avoir traitées dans des chambres de traitement (1), par un système de transport (13) dans une zone de projection d'agent de rinçage se trouvant dans les chambres de rinçage (2, 3) et à former la zone de projection en-dessous du trajet de transport avec au moins un tube fendu (7, 9) que l'agent de rinçage quitte sous pression.

2. Procédé suivant la revendication 1, caractérisé en ce qu'il consiste à prévoir au moins deux chambre de rinçage (2, 3) ayant des zones de projection d'agent de rinçage (7, 9), et à séparer le circuit de l'agent de rinçage de la première chambre de rinçage (2) du circuit général d'agent de rinçage de la deuxième chambre de rinçage (3), et à le fermer sur soi-même.

3. Procédé suivant l'une des revendications précédentes, caractérisé en ce qu'il consiste à faire suivre les deux premières chambres de rinçage (2, 3) ayant des zones de projection d'une autre chambre de rinçage (4) ayant des buses de rinçage normales (10, 11).

## Claims

1. A method of intensifying rinsing and cleansing processes for shaped parts (12), such as printed circuit boards, shaped etched components, and the like, in automatic rinsing and cleansing machines, wherein spray nozzles (10) are arranged above the transport system (13) for the shaped parts (12), characterised in that the shaped parts (12), which are provided with perforations, after treatment in active chambers (1), are led by means of a transport system (13) through a rinsing medium flooding stretch located in the rinsing chambers (2, 3); and that the flooding stretch is produced below the transport path by at least one slotted tube (7, 9), from which the rinsing medium issues under pressure.

2. A method according to Claim 1, characterised in that at least two rinsing chambers (2, 3) having rinsing medium flooding stretches (7, 9) are provided; and that the rinsing medium inlet of the first rinsing chamber (2) is separate and self-contained, in contrast to the general rinsing medium cycle of the second rinsing chamber (3).

3. A method according to one of the preceding Claims, characterised in that the first two rinsing chambers (2, 3) having a flooding stretch are followed by a further rinsing chamber (4) having normal rinsing nozzles (10, 11).